# FASCICULE DE BREVET EUROPEEN

(11) **EP 2 536 261 B1**
(45) Date de publication et mention de la délivrance du brevet: **06.09.2017**
(21) Numéro de dépôt: 12305580.8
(22) Date de dépôt: 25.05.2012
(51) Int. Cl.: H05K 7/14, H01G 4/32, H01G 4/228

(54) **Module electronique de puissance a capacite integree**
Elektronisches Leistungsmodul mit integrierter Kapazität
Electronic power module with integrated capacitance

(30) Priorité: 16.06.2011 FR 1155254
(43) Date de publication de la demande: 19.12.2012
(73) Titulaire: Valeo Systèmes de Contrôle Moteur, 95800 Cergy Saint Christophe (FR)
(72) Inventeur: Morliere, Benjamin, 95520 Osny (FR); Morelle, Jean-Michel, 45190 Beaugency (FR)

(56) Documents cités:
- EP-A2- 0 547 877
- EP-A2- 0 772 235
- EP-A2- 1 881 592
- US-A1- 2007 002 594

## Description

La présente invention se rapporte à un module électronique de puissance constitué d'un boîtier dans lequel est reçu au moins une puce ou composant électronique de puissance, par exemple un composant bipolaire tel qu'une diode, un composant tripolaire tel qu'un transistor de type MOS ou IGBT ou un composant de plus grande complexité tel qu'un circuit intégré de type ASIC, ou tout autre composant électronique de puissance analogue, et des moyens de liaison électronique destinés à transmettre la puissance à des éléments à l'extérieur du boîtier. La présente invention se rapporte également à un bloc de puissance comportant une pluralité de modules de puissance de ce genre ainsi qu'à un onduleur, notamment pour un véhicule électrique, comportant un bloc de puissance de ce genre. La présente invention se rapporte aussi à un véhicule, notamment électrique, comportant un onduleur du genre mentionné ci-dessus, notamment destiné à être disposé entre une batterie à haute tension du véhicule électrique et le secteur en vue du rechargement de la batterie.
On connaît déjà dans l'art antérieur des modules électronique de puissance, notamment de la demande de brevet français n° 0116153 (FR 2833802 A1) au nom de la demanderesse. Le document US 2007/0002594 A1 écrit un module selon le préambule de la revendication 1.

Ces modules de puissance (dits IML pour Insulated Molded Leadframe ou Grille de connexion moulée isolée) de l'art antérieur ont une durée de vie et une fiabilité insuffisante, notamment pour une utilisation dans le cadre d'un véhicule à moteur électrique.

La présente invention vise à surmonter les inconvénients de l'art antérieur en mettant à disposition un module de puissance qui a une plus grande durée de vie et est plus fiable, sans pour autant nuire à sa compacité, ce qui le rend particulièrement bien adapté à une utilisation dans le cadre d'un véhicule à moteur électrique.

Suivant l'invention telle que définie dans la revendication 1, un module électronique de puissance comportant un boîtier ayant un fond dans lequel est logé au moins un composant électronique de puissance et un couvercle, et en outre un dispositif formant capacité électrique est logé dans le boîtier.
En prévoyant ainsi une capacité, notamment sous la forme d'un film diélectrique, dans le module, on améliore la fiabilité de ce dernier et sa durée de vie, les composants électroniques du module étant mieux protégés contre l'apparition intempestive de surcharges dues aux perturbations CEM (Compatibilité Electro-Magnétique). En effet, la capacité intégrée étant plus proche des composants électroniques les perturbations CEM sont d'autant plus atténuées par rapport à l'art antérieur.
Dans le même temps, en prévoyant de disposer la capacité dans le boîtier du module, on conserve à l'ensemble une grande compacité et un faible encombrement, ce qui est particulièrement approprié à l'utilisation dans un véhicule à moteur électrique où la place et le poids sont comptés.
De préférence, le dispositif formant capacité électrique est une capacité constituée d'un film diélectrique entouré d'une enveloppe. Suivant l'invention, la capacité est disposée au dessus des composants électroniques du module, c'est à dire du côté de la paroi supérieure du boîtier. Suivant l'invention, la paroi supérieure est un couvercle du boîtier.
On obtient ainsi une protection efficace vis à vis des interférences électromagnétiques, notamment pour une carte PCB disposée au dessus du module.
Suivant un mode de réalisation particulièrement compact, il est formé dans le couvercle un logement auxiliaire dans lequel est reçu le dispositif formant capacité électrique. Par exemple, ce logement forme l'enveloppe de la capacité dans laquelle est reçu le film diélectrique.
La capacité constituée d'un film diélectrique intégré à l'intérieur même de la paroi supérieure du boîtier du module électronique de puissance forme un dispositif électronique de protection des circuits électroniques. Ainsi, on obtient un module électronique de puissance, qui est protégé électroniquement et qui en outre prend peu de place et a un faible encombrement.
Suivant un mode de réalisation préféré de l'invention, le ou les composants électroniques de puissance sont montés sur des conducteurs en forme de lames, notamment en cuivre, qui s'étendent suivant un même plan en étant mutuellement séparées les unes des autres par une matière isolante, les lames et la matière isolante intermédiaire formant le fond du boîtier.

De préférence, le logement auxiliaire formé dans le couvercle dans lequel est reçu le film diélectrique de la capacité s'étend sur une certaine partie de la surface du couvercle, notamment représente plus de 40% de la surface du couvercle, encore plus préférablement plus de 50%. Suivant l'invention, le module comprend en outre au moins un conducteur électrique relié à une borne du dispositif, ledit conducteur ayant au moins une portion s'étendant à l'extérieur du boîtier.
Suivant une variante, le module comprend un premier conducteur électrique ayant deux portions extérieures s'étendant depuis deux côtés opposés du boîtier.
Suivant une variante, le module comprend un second conducteur électrique ayant deux portions extérieures s'étendant depuis un même côté du boîtier.
Suivant une variante, le conducteur comprend au moins une portion venant en prise avec une paroi du boîtier de façon à être maintenu par le boîtier.
Suivant une variante, le conducteur comprend une portion de support sur laquelle le dispositif formant capacité électrique est positionné.
Suivant une variante, le module comprend au moins deux conducteurs électriques ayant ladite portion de support, et tels que les portions de support sont superposées et séparées par une couche d'isolant électrique.
Suivant un exemple particulier de cette variante, chaque conducteur électrique comprend au moins une portion de connexion s'étendant depuis ladite portion de support, de façon à venir en contact avec une borne du dispositif. Suivant une variante, le dispositif formant capacité est un condensateur.

Le module peut présenter l'une quelconque des variantes ou modes de réalisation présentés ci-dessus.
La présente invention vise également un assemblage comportant un module suivant l'invention et une carte de commande électronique, l'agencement étant tel que le dispositif formant capacité électrique est disposé entre les composants électroniques de puissance dans le module et la carte de commande électronique. La carte de commande électronique est par exemple une carte de circuit imprimé.
La présente invention vise également un bloc de puissance comportant une pluralité d'assemblages suivant l'invention.
La présente invention vise également un véhicule automobile, notamment un véhicule électrique, comportant un bloc de puissance suivant l'invention relié à une batterie du véhicule, notamment une batterie haute tension.

On décrit maintenant à titre d'exemple uniquement, un mode de réalisation de l'invention en se rapportant aux dessins dans lesquels :
- la figure 1: est une vue en perspective de dessus, partiellement arrachée d'un module électronique de puissance suivant l'invention ;
- la figure 2: représente une vue de côté et partiellement arrachée d'un module électronique de puissance selon l'invention ;
- la figure 3: est une vue en perspective de dessus du module électronique de puissance de la figure 1;
- la figure 4: représente sous la forme d' un schéma bloc un véhicule électrique comportant un bloc de puissance ayant une pluralité d'assemblages selon l'invention ;
- La figure 5: est une vue en perspective de dessus, partiellement arrachée, d'un module électronique de puissance suivant l'invention ;
- La figure 6: est une vue en perspective du module de la figure 5 sans son couvercle;
- La figure 7: est une autre vue en perspective du module de la figure 5 sans son couvercle ; et
- La figure 8: est une vue en perspective de dessous du module de la figure 5 sans son couvercle.

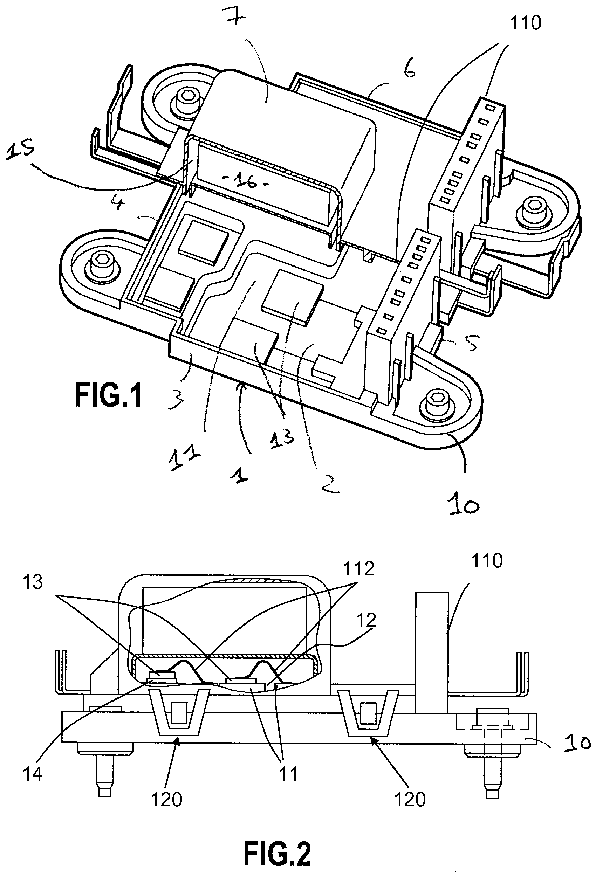

A la figure 1, il est représenté suivant une vue en perspective partiellement arrachée, un module électronique de puissance suivant un mode de réalisation de l'invention. Le module comporte un boîtier 1 ayant un fond 2, des parois 3, 4, 5 et 6 latérales et un couvercle 7. Quatre pattes 10 en forme d'oreille font saillie extérieurement du boîtier. Ces oreilles 10 permettent la fixation par vis du boîtier 1, notamment à un bloc de puissance. Des puces 13 ou composants électroniques de puissance sont montés sur le fond 2 du boîtier 1.

La figure 2 représente une vue de profil d'un exemple de module électronique selon l'invention. Dans cet exemple le couvercle 7 est fixé sur le fond 2 par des attaches 120. Des connecteurs 112 sont brasés ou soudés sur les composants de puissance 13. En outre, dans l'exemple représenté en figure 2, des conducteurs en forme de lames 11 métalliques en cuivre s'étendent dans le boîtier 1 en étant séparées par des espaces 12 intermédiaires remplis d'une matière diélectrique isolante. Ces lames 11 et la matière diélectrique dans les espaces intermédiaires 12 forment la paroi de fond 2 du boîtier 1. Sur les lames 11 conductrices sont montées les puces 13 ou composants électroniques de puissance brasés directement sur les lames 11 ou avec interposition d'un substrat 14 métallique. Les lames 11 font saillie à l'extérieur du boîtier 1 pour leur raccordement électrique avec l'extérieur du module. En outre, un matériau de remplissage, tel qu'une résine époxy ou un gel de silicone ou analogue emplit l'espace intérieur libre du boîtier autour des composants de puissance.

Il est formé dans le couvercle 7 un logement auxiliaire recevant un dispositif formant capacité électronique. Ici, le logement auxiliaire correspond à une enveloppe 15 fermée dans laquelle est reçu un film 16 diélectrique pour ainsi former une capacité afin de protéger électriquement les composants électroniques du module de puissance.

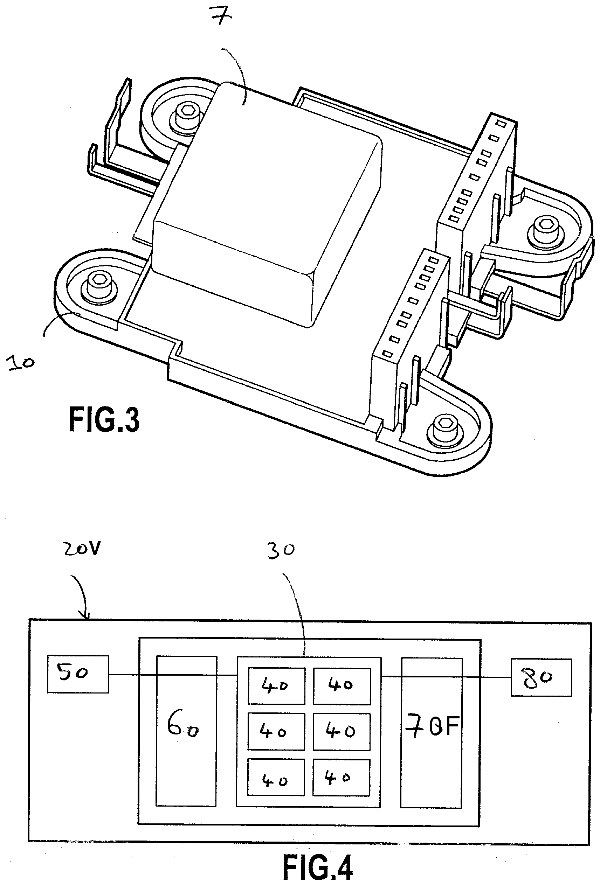

La figure 3 présente une vue en perspective de dessus du module électronique de puissance. De préférence, l'enveloppe 15 et le film 16 reçu en son sein s'étendent sur une zone du couvercle 7 qui correspond à une majeure partie du couvercle 7, c'est-à-dire de la paroi supérieure du module électronique de puissance, et notamment a une surface supérieure à 40% de préférence supérieure à 50% de la surface du couvercle 7 du module. On obtient ainsi l'effet supplémentaire qui consiste en une protection CEM (Compatibilité Electro-Magnétique) par le film diélectrique 16, notamment pour une carte PCB de commande électronique disposée au dessus du couvercle 7 du module et reliée électriquement au module. Notamment, la carte électronique de commande est reliée au module par l'intermédiaire de plots de connexion 110.
Par exemple, le film diélectrique a une épaisseur comprise entre 12 et 25 mm, notamment égale à 18 mm, et une largeur et une longueur comprises entre 30 et 60 mm, notamment égales respectivement à 40 et 46 mm. Le boîtier 1a par exemple une forme parallélépipédique. Par exemple, à la figure 3, le boîtier 1a une largeur de 100 mm et une longueur de 100 mm également.

A la figure 4, il est représenté un véhicule 20V électrique de manière schématique et synoptique. Il comporte un bloc 30 de puissance constitué d'une pluralité d'assemblages 40. Chaque assemblage 40 comprend un module électronique de puissance comme décrit précédemment et une carte de commande électronique. Le bloc de puissance 30 comprend notamment six assemblages 40. Le bloc 30 électronique est relié à une batterie 50 du véhicule avec une interposition d'un dispositif 60 formant filtre et peut être relié, également avec interposition d'un bloc filtre 70F au secteur 80 pour la recharge de la batterie 50.
Dans le cadre de la présente demande, une électronique de puissance désigne un composant, un module ou un bloc aptes à transmettre un signal électrique ayant une puissance comprise entre 40 et 100kW. Notamment, la carte électronique commande les composants du module électronique de puissance.
Par exemple, le film diélectrique 16 est en polypropylène permettant de supporter les températures de fonctionnement du module électronique de puissance. Notamment, le film diélectrique en polypropylène peut supporter une température allant jusqu'à 85°C.

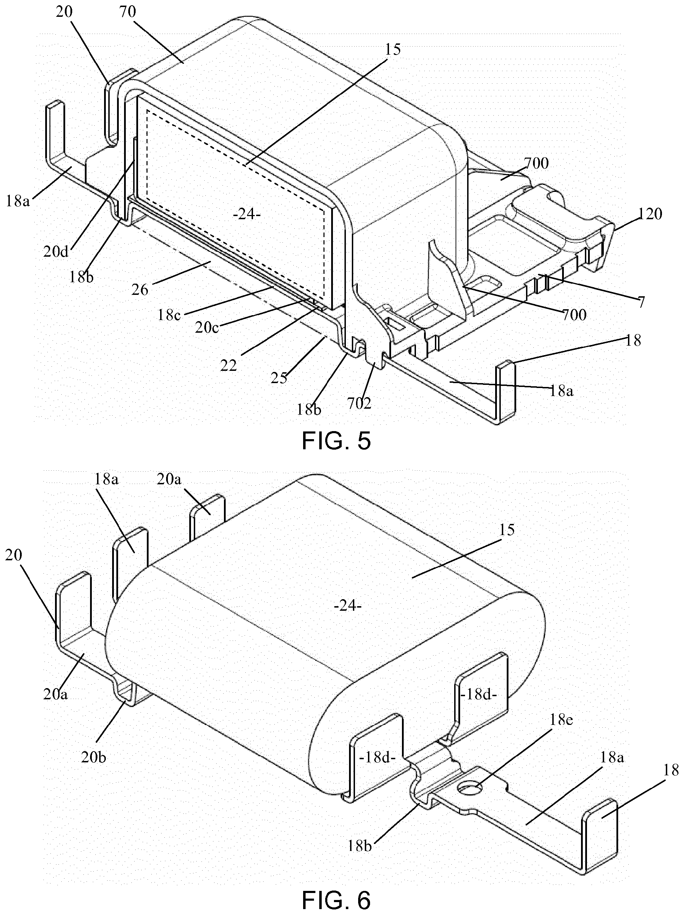

La figure 5 présente une vue de dessus partiellement arrachée d'un autre exemple d'un module de puissance selon l'invention. Sur la figure, seule une portion du couvercle 7 muni du dispositif 24 formant capacité est représenté. Le fond 2 du boîtier 1 et les lames 11 sur lesquelles sont montées les composants électroniques 13 de puissance sont similaires à ceux précédemment décrits et ne sont pas représentés.

Le dispositif 24 est reçu dans le logement auxiliaire 70 qui comprend des nervures 700. Les nervures 700 améliorent le maintien des parois du logement auxiliaire 70 avec les autres portions du couvercle 7.
En particulier, le dispositif formant capacité est un condensateur 24 dont l'enveloppe 15 est distincte du couvercle 7. Par exemple, le condensateur 24 est à film diélectrique (non représenté) connu en soi. De préférence, le film diélectrique du condensateur est en polypropylène.

Le module électronique comprend des conducteurs électriques 18, 20 sous forme de lame, reliés respectivement à une borne du dispositif 24. Ces conducteurs électriques 18, 20 seront mieux décrits en faisant également référence aux figures 6 à 8 qui présentent des vues en perspective du dispositif 24 muni des conducteurs électriques 18, 20.

Les conducteurs 18, 20 ont des portions 18a, 20a qui s'étendent à l'extérieur du boîtier 1. Ainsi, le dispositif 24 peut être connecté électriquement de façon directe depuis l'extérieur du boîtier 1. Pour chaque liaison électrique du dispositif 24 un seul conducteur 18, 20 est utilisé depuis le dispositif 24 jusqu'à l'extérieur du boîtier, ce qui limite les soudures et simplifie la connexion électrique du dispositif 24.

Un premier conducteur électrique 18 a deux portions extérieures 18a qui s'étendent depuis deux côtés opposés du boîtier. Un second conducteur électrique 20 a deux portions extérieures qui s'étendent depuis un même côté du boîtier.

Les portions extérieures 18a, 20a ont par exemple des parties coplanaires qui s'étendent dans un plan parallèle au fond 2 du boîtier 1. Les portions extérieures 18a, 20a peuvent présenter un coude qui facilite la connexion électrique avec un conducteur extérieur. La partie coudée est perpendiculaire au plan commun des parties coplanaires.

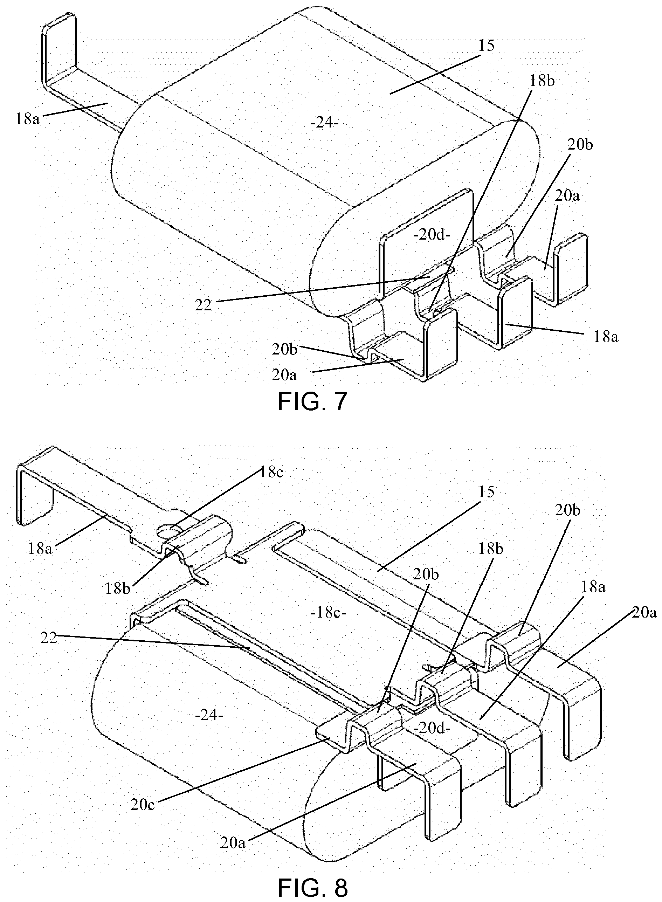

Les conducteurs 18, 20 comprennent en outre une portion de support 18c, 20c sur laquelle le dispositif 24 formant capacité électrique est positionné. Les portions de support 18c, 20c sont superposées et séparées par une couche d'isolant électrique 22. Ces portions de support sont mieux visibles en figure 8. Les portions de support 18c, 20c sont des lames qui relient les deux portions extérieures 18a, 20a. La portion de support 20c du second conducteur 20 peut comprendre une partie s'étendant sous la portion de support 18c du premier conducteur 18. Cette partie n'est pas visible en figure 8 car elle est recouverte par l'isolant 22, mais elle peut être observée en figure 5.

Chaque conducteur électrique 18, 20 comprend au moins une portion de connexion 18d, 20d qui s'étend depuis la portion de support 18c, 20c pour venir en contact avec une borne du dispositif 24. En particulier, les portions de connexion 18d, 20d sont formées d'une pliure depuis la portion de support 18c, 20c pour venir en contact avec les bornes du dispositif 24.

Le premier conducteur électrique 18 comprend deux portions de connexion 18d qui s'étendent depuis la portion de support 18c pour venir en contact avec une borne du dispositif 24. Le second conducteur électrique 20 comprend une portion de connexion 20d qui vient en contact avec une autre borne du dispositif 24.

Les portions de connexion 18d, 20d sont rendues solidaires aux bornes du dispositif 24, par exemple par soudage ou brasage, de sorte que le dispositif 24 peut être manipulé à l'aide des conducteurs électriques 18, 20. Le dispositif 24 peut également être fixé sur le portions de support 18c, 20c, ce qui améliore son maintien et sa manipulation par les conducteurs électriques 18, 20. Le dispositif 24 peut alors être facilement monté dans le couvercle 7.
A cet effet, les conducteurs électriques 18, 20 comprennent en outre des portions 18b, 20b qui viennent en prise avec une paroi du boîtier de façon à être maintenu par le boîtier. En particulier, les portions 18b, 20b viennent en prise avec le couvercle 7. Pour cela, le premier conducteur 18 comprend une ouverture 18e qui reçoit un pion 702 du couvercle 7 comme représenté en figure 5. Le pion 702 et l'ouverture 18e permettent de guider le couvercle 7 sur l'ensemble constitué des connecteurs 18, 20 et du dispositif 24. Les portions 18b, 20b comprennent une déformation qui reçoit un muret du couvercle 7.
Une fois le dispositif 24 monté dans le logement auxiliaire 70 du couvercle 7 à l'aide des conducteurs 18, 20, l'ensemble peut être rempli par une résine 26. Celle-ci s'introduit dans les interstices pour améliorer le maintien de l'ensemble après son durcissement. Après remplissage, le niveau de résine affleure au couvercle 7 comme représenté par la ligne 25 en pointillé. Le couvercle 7 peut alors s'emboîter avec le fond 2 du boîtier 1 par l'intermédiaire des attaches 120 comme décrit précédemment.
Il est entendu que l'invention ne se limite pas aux exemples présentés.

## Revendications

1. Module électronique de puissance comportant un boîtier (1) ayant un fond (2) dans lequel est logé au moins un composant (13) électronique de puissance et un couvercle (7), et un dispositif (24) formant capacité électrique logé dans le boîtier (1), le dispositif (24) étant disposé au dessus des composants (13) électroniques du module, c'est à dire du côté du couvercle (7) du boîtier (1), ledit module comprenant en outre au moins un conducteur électrique (18, 20) relié à une borne du dispositif (24), ledit conducteur (18, 20) ayant au moins une portion extérieure (18a, 20a) s'étendant à l'extérieur du boîtier (1) pour la connexion électrique avec un conducteur extérieur, et **caractérisé en ce que** ledit conducteur (18, 20) comprend en outre au moins une portion (18b, 20b) qui vient en prise avec le couvercle (7) du boîtier (1) de façon à être maintenu par le boîtier (1).

2. Module suivant la revendication 1, **caractérisé en ce qu'**il est formé dans le couvercle (7) un logement auxiliaire (70) dans lequel est reçu le dispositif (24) formant capacité électrique.

3. Module suivant les revendications 1 ou 2, dans lequel le dispositif (24) est une capacité constituée d'un film diélectrique entouré d'une enveloppe (15).

4. Module suivant les revendications 2 et 3, **caractérisé en ce que** le logement auxiliaire forme l'enveloppe (15) de la capacité, dans laquelle est reçu le film diélectrique (16).

5. Module suivant l'une des revendications précédentes, comprenant un premier conducteur électrique (18) ayant deux portions extérieures (18a) s'étendant depuis deux côtés opposés du boîtier (1).

6. Module suivant l'une des revendications précédentes, comprenant un second conducteur électrique (20) ayant deux portions extérieures (20a) s'étendant depuis un même côté du boîtier (1).

7. Module suivant l'une des revendications précédentes, dans lequel le conducteur (18, 20) comprend une portion de support (18c, 20c) sur laquelle le dispositif (24) formant capacité électrique est positionné.

8. Module suivant la revendication 7, comprenant au moins deux conducteurs électriques (18, 20) ayant ladite portion de support (18c, 20c), et tels que les portions de support (18c, 20c) sont superposées et séparées par une couche d'isolant électrique (22) .

9. Module suivant la revendication 8, dans lequel chaque conducteur électrique (18, 20) comprend au moins une portion de connexion (18d, 20d) s'étendant depuis ladite portion de support (18c, 20c), de façon à venir en contact avec une borne du dispositif (24).

10. Module suivant l'une des revendications précédentes, dans lequel le dispositif formant capacité est un condensateur (24).

11. Module suivant l'une des revendications précédentes, **caractérisé en ce que** le ou les composants (13) électroniques de puissance sont montés sur des conducteurs en forme de lames (11), notamment en cuivre, qui s'étendent suivant un même plan en étant mutuellement séparées (12) les unes des autres par une matière isolante, les lames (11) et la matière isolante intermédiaire formant le fond (2) du boîtier (1).

12. Module suivant l'une des revendications 2 à 11, **caractérisé en ce que** le logement auxiliaire (70) formé dans le couvercle (7) dans lequel est reçu le film diélectrique (16) de la capacité s'étend sur une majeure partie de la surface de la paroi supérieure (7), notamment représente plus de 40% de la surface du couvercle (7), encore plus préférablement plus de 50%.

13. Assemblage (40) comportant un module suivant l'une des revendications précédentes et une carte de commande électronique, l'agencement étant tel que le dispositif (24) formant capacité électrique est disposé entre les composants (13) électroniques de puissance dans le module et la carte de commande électronique.

14. Bloc de puissance (30) comportant une pluralité d'assemblages (40) suivant la revendication 13.

15. Véhicule automobile, notamment un véhicule électrique (20V), comportant un bloc (30) de puissance suivant la revendication 14 relié à une batterie (50) du véhicule (20V), notamment une batterie haute tension.

## Patentansprüche

1. Elektronisches Leistungsmodul, das ein Gehäuse (1) mit einem Boden (2), in dem mindestens ein elektronisches Leistungsbauteil (13) untergebracht ist, und mit einem Deckel (7) und eine einen elektrischen Kondensator bildende Vorrichtung (24) aufweist, die im Gehäuse (1) untergebracht ist, wobei die Vorrichtung (24) oberhalb der elektronischen Bauteile (13) des Moduls, d.h. auf der Seite des Deckels (7) des Gehäuses (1), angeordnet ist,
wobei das Modul außerdem mindestens einen elektrischen Leiter (18, 20) enthält, der mit einer Klemme der Vorrichtung (24) verbunden ist, wobei der Leiter (18, 20) mindestens einen äußeren Abschnitt (18a, 20a) hat, der sich für die elektrische Verbindung mit einem äußeren Leiter außerhalb des Gehäuses (1) erstreckt, und **dadurch gekennzeichnet, dass** der Leiter (18, 20) außerdem mindestens einen Abschnitt (18b, 20b) enthält, der mit dem Deckel (7) des Gehäuses (1) in Eingriff kommt, um vom Gehäuse (1) gehalten zu werden.

2. Modul nach Anspruch 1, **dadurch gekennzeichnet, dass** im Deckel (7) eine Hilfsaufnahme (70) geformt ist, in der die einen elektrischen Kondensator formende Vorrichtung (24) aufgenommen wird.

3. Modul nach den Ansprüchen 1 oder 2, wobei die Vorrichtung (24) ein Kondensator ist, der aus einer von einer Hülle (15) umgebenen dielektrischen Folie besteht.

4. Modul nach den Ansprüchen 2 und 3, **dadurch gekennzeichnet, dass** die Hilfsaufnahme die Hülle (15) des Kondensators formt, in der die dielektrische Folie (16) aufgenommen wird.

5. Modul nach einem der vorhergehenden Ansprüche, das einen ersten elektrischen Leiter (18) enthält, der zwei äußere Abschnitte (18a) hat, die sich von zwei gegenüberliegenden Seiten des Gehäuses (1) erstrecken.

6. Modul nach einem der vorhergehenden Ansprüche, das einen zweiten elektrischen Leiter (20) enthält, der zwei äußere Abschnitte (20a) hat, die sich von der gleichen Seite des Gehäuses (1) erstrecken.

7. Modul nach einem der vorhergehenden Ansprüche, wobei der Leiter (18, 20) einen Trägerabschnitt (18c, 20c) enthält, auf dem die einen elektrischen Kondensator formende Vorrichtung (24) positioniert ist.

8. Modul nach Anspruch 7, das mindestens zwei elektrische Leiter (18, 20) enthält, die den Trägerabschnitt (18c, 20c) haben, und derart, dass die Trägerabschnitte (18c, 20c) übereinander liegen und durch eine elektrische Isolierschicht (22) getrennt sind.

9. Modul nach Anspruch 8, wobei jeder elektrische Leiter (18, 20) mindestens einen Verbindungsabschnitt (18d, 20d) enthält, der sich vom Trägerabschnitt (18c, 20c) 20c) erstreckt, um mit einer Klemme der Vorrichtung (24) in Kontakt zu kommen.

10. Modul nach einem der vorhergehenden Ansprüche, wobei die einen Kondensator formende Vorrichtung ein Kondensator (24) ist.

11. Modul nach einem der vorhergehenden Ansprüche, **dadurch gekennzeichnet, dass** das oder die elektronischen Leistungsbauteile (13) auf plattenförmige Leiter (11), insbesondere aus Kupfer, montiert sind, die sich in der gleichen Ebene erstrecken, indem sie durch ein Isoliermaterial voneinander getrennt sind (12), wobei die Platten (11) und das dazwischenliegende Isoliermaterial den Boden (2) des Gehäuses (1) formen.

12. Modul nach einem der Ansprüche 2 bis 11, **dadurch gekennzeichnet, dass** die im Deckel (7) geformte Hilfsaufnahme (70), in der die dielektrische Folie (16) des Kondensators aufgenommen wird, sich über einen größeren Teil der Fläche der oberen Wand (7) erstreckt, insbesondere mehr als 40% der Fläche des Deckels (7), noch bevorzugter mehr als 50% darstellt.

13. Anordnung (40), die ein Modul nach einem der vorhergehenden Ansprüche und eine elektronische Steuerkarte aufweist, wobei die Anordnung derart ist, dass die einen elektrischen Kondensator bildende Vorrichtung (24) zwischen den elektronischen Leistungsbauteilen (13) im Modul und der elektronischen Leistungskarte angeordnet ist.

14. Leistungsblock (30), der eine Vielzahl von Anordnungen (40) nach Anspruch 13 aufweist.

15. Kraftfahrzeug, insbesondere elektrisches Fahrzeug (20V), das einen Leistungsblock (30) nach Anspruch 14 verbunden mit einer Batterie (50) des Fahrzeugs (20V), insbesondere einer Hochspannungsbatterie, aufweist.

## Claims

1. Electronic power module including an enclosure (1) having a base (2) in which is housed at least one electronic power component (13) and a cover (7), and a device (24) forming an electrical capacitance housed in the enclosure (1), the device (24) being placed above the electronic components (13) of the module, in other words on the cover side (7) of the enclosure (1),
the said module further comprising at least one electrical conductor (18, 20) connected to a terminal of the device (24), the said conductor (18, 20) having at least one outer portion (18a, 20a) extending outside the enclosure (1) for the electrical connection to an outside conductor, and
**characterized in that** the said conductor (18, 20) further comprises at least one portion (18b, 20b) which engages with the cover (7) of the enclosure (1) so as to be supported by the enclosure (1).

2. Module according to Claim 1, **characterized in that** an auxiliary housing (70) is formed in the cover (7) and the device (24) forming an electrical capacitance is received in this housing.

3. Module according to Claim 1 or 2, in which the device (24) is a capacitance composed of a dielectric film surrounded by a casing (15).

4. Module according to Claims 2 and 3, **characterized in that** the auxiliary housing forms the casing (15) of the capacitance, in which the dielectric film (16) is received.

5. Module according to any one of the preceding claims, comprising a first electrical conductor (18) having two outer portions (18a) extending from two opposite sides of the enclosure (1).

6. Module according to any one of the preceding claims, comprising a second electrical conductor (20) having two outer portions (20a) extending from the same side of the enclosure (1).

7. Module according to any one of the preceding claims, wherein the conductor (18, 20) comprises a support portion (18c, 20c) on which the device (24) forming an electrical capacitance is positioned.

8. Module according to Claim 7, comprising at least two electrical conductors (18, 20) which each have the said support portion (18c, 20c), and are such that the support portions (18c, 20c) are superimposed and separated by a layer of electrical insulation (22).

9. Module according to Claim 8, wherein each electrical conductor (18, 20) comprises at least one connecting portion (18d, 20d) extending from the said support portion (18c, 20c) so as to come into contact with a terminal of the device (24).

10. Module according to any one of the preceding claims, wherein the device forming a capacitance is a capacitor (24).

11. Module according to any one of the preceding claims, **characterized in that** the electronic power component or components (13) are mounted on conductors in the form of strips (11), notably made of copper, which extend in the same plane while being separated (12) from each other by an insulating material, the strips (11) and the intermediate insulating material forming the base (2) of the enclosure (1) .

12. Module according to any one of Claims 2 to 11, **characterized in that** the auxiliary housing (70) formed in the cover (7) in which the dielectric film (16) of the capacitance is accommodated extends over a major part of the surface of the upper wall (7), which is, notably, more than 40% of the surface area of the cover (7), or, even more preferably, more than 50% of the surface area.

13. Assembly (40) including a module according to any one of the preceding claims, and an electronic control card, the arrangement being such that the device (24) forming an electrical capacitance is placed between the electronic power components (13) in the module and the electronic control card.

14. Power unit (30) including a plurality of assemblies (40) according to Claim 13.

15. Motor vehicle, notably an electric vehicle, (20V), including a power unit (30) according to Claim 14, connected to a battery (50) of the vehicle (20V), notably a high-voltage battery.
